**Europäisches Patentamt**

(19) **European Patent Office**

**Office européen des brevets**

(11) Publication number: **0 040 001**
**B1**

(12) **EUROPEAN PATENT SPECIFICATION**

(45) Date of publication of patent specification: **01.07.87**

(51) Int. Cl.⁴: **G 11 C 7/00, G 11 C 11/24**

(21) Application number: **81301608.6**

(22) Date of filing: **13.04.81**

(54) A dynamic semiconductor memory device with decreased clocks.

(30) Priority: **15.04.80 JP 49438/80**

(43) Date of publication of application:
**18.11.81 Bulletin 81/46**

(45) Publication of the grant of the patent:
**01.07.87 Bulletin 87/27**

(84) Designated Contracting States:
**DE FR GB**

(56) References cited:
**DE-A-2 758 810**
**DE-A-2 801 255**
**FR-A-2 412 982**
**US-A-3 838 295**
**US-A-4 081 701**
**US-A-4 144 590**
**US-A-4 162 416**
**US-A-4 166 225**

**IBM TECHNICAL DISCLOSURE BULLETIN, vol.
17, no. 9, February 1975, ARMONK (US), J.L.
CHU et al.: "Low-power, high-speed sense
latch", pages 2582-2583**

(73) Proprietor: **FUJITSU LIMITED**
**1015, Kamikodanaka Nakahara-ku
Kawasaki-shi Kanagawa 211 (JP)**

(72) Inventor: **Takemae, Yoshihiro
20-5-9-301, Utsukushigaoka 1-chome Midori-ku
Yokohama-shi Kanagawa 227 (JP)**
Inventor: **Nozaki, Shigeki
473-4-203, Hisasue Takatsu-ku
Kawasaki-shi Kanagawa 213 (JP)**
Inventor: **Mezawa, Tsutomu
81, Aza Muranishi Oaza Tsuruga Ikkimachi
Aizuwakamatsu-shi Fukushima 965 (JP)**

(74) Representative: **Sunderland, James Harry et al
HASELTINE LAKE & CO Hazlitt House 28
Southampton Buildings Chancery Lane
London WC2A 1AT (GB)**

(56) References cited:
**IEEE INTERNATIONAL SOLID STATE CIRCUITS
CONFERENCE, 13. February 1980, NEW YORK
(US), K. OHTA et al.: "A stacked high capacitor
RAM", pages 66-67**

**IEEE INTERNATIONAL SOLID STATE
CIRCUITS, 15. February 1979, NEW YORK (US),
R.C. FOSS: "The design of MOS dynamic
RAMs", pages 140-141**

Courier Press, Leamington Spa, England.

## Description

### Background of the invention

The present invention relates to a dynamic semiconductor memory device with decreased clocks, and more particularly, to an improvement of a semiconductor memory device having dynamic memory cells each of which comprises one transistor and one capacitor.

In general, a dynamic semiconductor memory device comprises a number of memory cells arranged in an array or matrix consisting of intersecting word lines and bit lines. Each of the bit lines is associated with a sense amplifier. Each of the memory cells connected to one sense amplifier comprises one transistor and one capacitance. During a precharge period, a bit line is charged to $V_{CC}$ (power supply voltage). In a reading operation, the sense amplifier amplifies the stored charge signal so as to be read out. After the reading operation, a dynamic restore operation is effected by charging the capacitance with charges on the bit line.

A cross reference in this field is: IEEE Journal of Solid-State Circuits, Vol. SC-15, No. 5, October 1980, pp 831—839, "A High Performance Sense Amplifier for a 5V Dynamic RAM".

In an example of the prior-art devices, there is known a dynamic semiconductor memory device in which a pull up circuit for charging up each bit line after the reading operation is not included. The problem in this conventional device is that, after the reading operation, charges on each bit line have leaked out through the associated sense amplifier or due to a junction leak to lower the potential of the bit line so that the dynamic restore operation is not sufficiently effected, as hereinafter described in detail. Since charges are not sufficiently restored in the cell capacitance, there are the disavantages of low tolerance against soft errors which have been taken into consideration in recent years, or of the common occurrence of restore errors.

In another example of a known dynamic semiconductor memory device, a pull up circuit is associated with each bit line so that each bit line is charged up after the reading operation. In this second conventional example, the above mentioned problem of an insufficient restore operation is eliminated. However, since a number of clock signals must be applied to many points of the dynamic semiconductor memory device of this second conventional example, difficulties occur in setting the potential levels of these clock signals, or in determining the timings of these clock signals to be applied.

In an article by Chu and Kalter, entitled "Low-power High-speed Sense Latch" in IBM Technical Disclosure Bulletin, vol. 17, number 9, February 1975, pages 2582 to 2583, there is disclosed a sense latch as in the precharacterising part of the claim.

The sense latch of Fig. 1 of D1 also has transistores ($T_9$ and $T_8$) which in dependence upon the precharging clock signal precharge the gates of the first and second switching transistors to provide a precharge voltage level at those gates equal to the levels at the first and second nodes (A and B), to precondition the sense latch for operation.

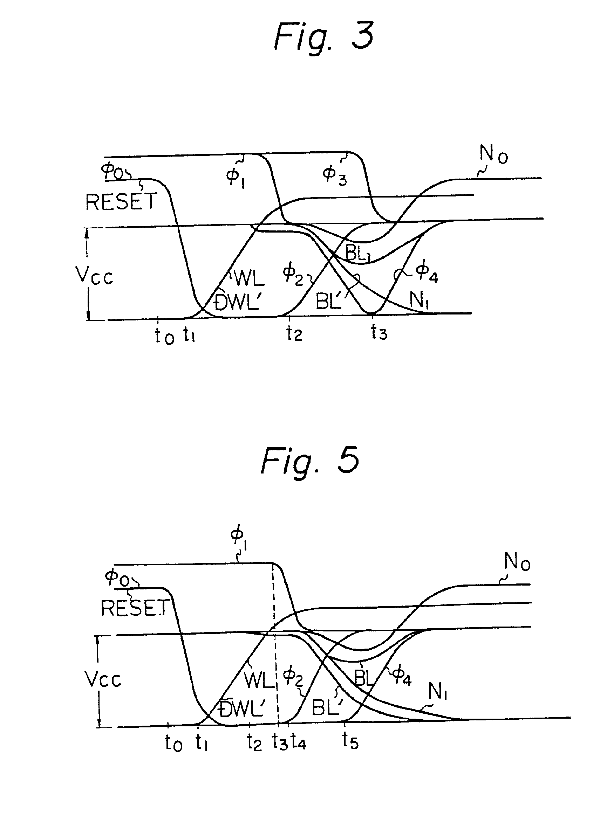

US—A—4 144 590 (see Fig. 3) discloses a dynamic memory device comprising:

a plurality of dynamic memory cells arranged in a matrix;

a sense amplifier (30) associated with a pair of half-column lines (37, 38) connected to memory cells of the matrix, having a first node (35) connected to one of said half-column lines (37) and a second node (36) connected to the other of said half-column lines (38), and comprising a pair of cross-coupled driver transistors (31, 32) connected between the respective half-column lines and a common connection point (50), and a further transistor (51, 52) connected between said common connection point (50) and a lower potential power supply line of the device;

circuitry associated with said pair of half-column lines;

in which said circuitry comprises:

a first gated capacitor (63) having one end connected to receive a clock signal ($\phi_2$);

a second gated capacitor (64) having one end connected to receive said clock signal $\phi_2$;

a first load transistor (33) connected between a higher potential power supply line (Vdd) and said one (37) of said half-column lines, and having a gate connected to the other end of the first capacitor (63);

a second load transistor (34) connected between said higher potential power supply line (Vdd) and said other of said half-column lines, and having a gate connected to the other end of the second capacitor (64);

a third transistor (65) connected between the gate of said first load transistor (33) and the said one of said half-column lines, and having a gate connected to said second node (36);

a fourth transistor (66) connected between the gate of said second load transistor (34) and the said other of said half-column lines and having a gate connected to said first node (35);

a first precharging transistor (49) connected in "parallel" to said first load transistor (33), and having a gate adapted to receive a clock signal $\phi^-$ for precharging said one of said half-column lines; and a second precharging transistor (49) connected in "parallel" to said second load transistor (34), and having a gate adapted to receive the clock signal $\phi^-$ for precharging said other of said half-column lines.

In this sense amplifier the gated capacitors are not precharged through additional precharge transistors as in the IBM TDB but simultaneously with the precharging of the bit lines through the third and fourth transistors (65, 66).

According to the present invention there is provided a dynamic semiconductor memory device comprising:

a plurality of dynamic memory cells arranged in a matrix;

a sense amplifier associated with a pair of bit lines connected to memory cells of the matrix, having a first node associated with one of said bit lines and a second node associated with the other of said bit lines for providing the outputs of said sense amplifier, and comprising first and second sense amplifier transistors, the drains or sources of the respective transistors being connected to respective one of the first and second nodes, the gate of each transistor being connected to the drain or souce of the other, and the sources or drains of the transistors being connected to one another at a common connection point, and a further transistor connected between said common connection point and a lower potential power supply line of the device;

pull up circuitry associated with said pair of bit lines for charging up the bit lines;

in which said pull up circuitry comprises:

a first capacitor having one end connected to receive a clock signal generated following a memory cell reading operation, for a restoration operation for restoring charge to a read memory cell;

a second capacitor having one end connected to receive said clock signal;

a first switching transistor connected between a higher potential power supply line and said one of said bit lines, and having a gate connected to the other end of the first capacitor;

a second switching transistor connected between said higher potential power supply line and said other of said bit lines, and having a gate connected to the other end of the second capacitor;

a third switching transistor connected between the gate of said first switching transistor and the said common connection point, and having a gate connected to said second node;

a fourth switching transistor connected between the gate of said second switching transistor and the said common connection point, and having a gate connected to said first node;

a first precharging transistor connected between a potential supply line and said one of said bit lines, and having a gate adapted to receive a precharging clock signal for precharging said one of said bit lines;

a second precharging transistor connected between the potential supply line and said other of said bit lines, and having a gate adapted to receive said precharging clock signal for precharging said other of said bit lines; characterised in that

the said other end of the first capacitor is connected solely to the gate of the first switching transistor and to the third switching transistor;

the said other end of the second capacitor is connected solely to the gate of the second switching transistor and to the fourth switching transistor; and in that

the said potential supply line with the which the first and second precharging transistors are connected in said higher potential power supply line;

a first transfer gate transistor is connected between said one of said pair of bit lines and said first node; and

a second transfer gate transistor is connected between said other of said pair of bit lines and said second node;

said first transfer gate transistor and said second transfer gate transistor having gates for receiving a further clock signal for turning those transistors off after the potentials of said pair of bit lines begin to change from a precharged level during a memory cell reading operation.

Brief description of the drawings

The present invention may best be understood by reference to the following description of the preferred embodiments, when read in conjunction with the accompanying drawings, in which like reference characters designate the same or similar parts throughout the figures thereof and wherein:

Fig. 1 is a circuit diagram illustrating a part of a conventional dynamic semiconductor memory device having no pull up circuit;

Fig. 2 is a circuit diagram illustrating a part of another conventional dynamic semiconductor memory device having pull up circuits;

Fig. 3 is a time chart illustrating waveforms for the circuit of Fig. 2;

Fig. 4 is a circuit diagram illustrating a part of a dynamic semiconductor memory device according to an embodiment of the present invention, and;

Fig. 5 is a time chart illustrating waveforms for the circuit of Fig. 4.

Description of preferred embodiment

Before describing the preferred embodiment of the present invention, two examples of the conventional dynamic semiconductor mamory devices will first be explained.

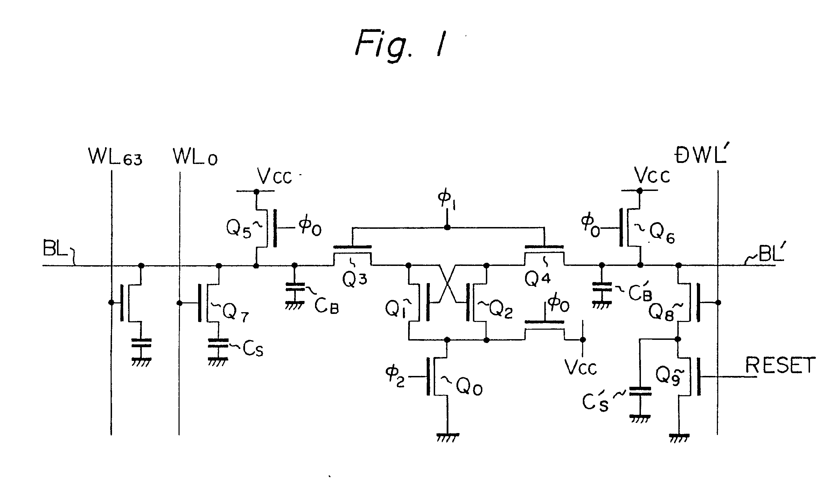

Fig. 1 is a circuit diagram illustrating a part of the first example of the conventional devices. Referring to Fig. 1, $Q_0$, $Q_1$, ..., and $Q_9$ represent transistors; BL and BL' represent bit lines; $C_S$ and $C_S'$ represent memory capacitors; $C_B$ and $C_B'$ represent capacitors of the bit line BL and BL', respectively; $V_{CC}$ represents a power supply line or a power supply voltage; and, $\phi_0$, $\phi_1$ and $\phi_2$ represent clock signals.

The drain (or source) of the trnasistor $Q_1$ is connected to the gate of the transistor $Q_2$. Also, the drain (or source) of the transistor $Q_2$ is connected to the gate of the transistor $Q_1$. Thus, the transistors $Q_1$ and $Q_2$ are connected in intersection to constitute a sense amplifier. The transistor $Q_0$ acts as a transfer gate to connect or disconnect the sense amplifier to or from the ground depending on whether the clock signal $\phi_2$ of $V_{CC}$ level is applied or not, respectively, to the gate of the transistor $Q_0$. The transistors $Q_3$ and $Q_4$ acts as transfer gates to connect or disconnect the sense amplifier to or from the bit lines BL and BL', respectively, depending on whether the clock signal $\phi_1$ having a level higher

than $V_{CC}$ plus VTH, where VTH is the threshold voltage of the transistors $Q_3$ and $Q_4$, is applied or not, respectively, to the gates of the transistors $Q_3$ and $Q_4$. The transistors $Q_5$ and $Q_6$ act as switching transistors for connecting or disconnecting the power supply line $V_{CC}$ to or from the bit lines BL and BL', respectively. Also, the transistors $Q_7$ and $Q_8$ act as transfer gates for charges stored or to be stored in the memory capacitors $C_S$ and $C_S'$, respectively. On the left-hand side in Fig. 1, the transistor $Q_7$ having a gate connected to a word line $WL_0$, and the memory capacitor $C_S$ constitute a real memory cell. On the right-hand side in Fig. 1, the transistor $Q_8$ having a gate connected to a dummy word line DWL', and the memory capacitor $C_S'$ constitute a dummy memory cell. The transistor $Q_9$ connected between the source (or drain) of the transistor $Q_8$ and the ground is a switching transistor for connecting or disconnecting the source (or drain) of the transistor $Q_8$ to or from the ground. The gate of the transistor $Q_7$ in the real memory cell is connected to the word line $WL_0$. There are a number of word lines, and in this example, there are word lines $WL_0$ through $WL_{63}$ which intersect the bit line BL. Each word line is associated with one memory cell connected to the bit line BL. Therefore, there are a number of memory cells associated with the bit line BL. Only one dummy memory cell is connected to the bit line BL'. Also, there are a number of other word lines intersecting the bit line BL', each of which being associated with one memory cell (not shown) connected to the bit line BL', and another dummy word line intersecting the bit line BL, the dummy word line being associated with another dummy memory cell (not shown), although these word lines and the dummy bit line are not illustrated in Fig. 1 for the sake of simplicity.

The operation of the circuit of Fig. 1 will be briefly explained as follows.

There is no problem in the restore operation after information "0" has been read from a memory cell. Therefore, in the following description, let it be assumed that the original information stored in the capacitor $C_S$ is "1".

During the precharge period, the dummy memory capacitor $C_S'$ stores information "0" by using a reset signal RESET to ensure charges in the dummy memory capacitor $C_S'$ to flow through the transistor $Q_9$ to the ground.

During the reading period, the sense amplifier amplifies the pontential difference between the bit lines BL and BL'. The potential difference is caused by the difference between currents being conducted from the bit line BL through the transistor $Q_7$ into the memory capacitor $C_S$ and currents being conducted from the bit line BL' through the transistor $Q_8$ into the dummy memory capacitor $C_S'$.

After the reading operation, the restore operation is effected to keep the originally stored information, unless new information is to be written. When the originally stored information is "1", the restore operation is effected by conducting charges, precharged in the capacitance $C_B$ of the bit line BL, into the memory capacitor $C_S$.

However, during the time the sense amplifier is being operated, a part of the charges stored in the capacitance $C_B$ of the bit line BL leak through the sense amplifier, resulting in the potential of the bit line BL being lowered. Therfore, charges restored from the bit line BL to the memory capacitor $C_S$ tend to be insufficient to keep the originally stored information. As a result, by using the circuit of Fig. 1, there are the disadvantages of low tolerance against soft errors or of the common occurrence of restore errors. Particularly, recent dynamic semiconductor memory devices tend to employ a 5 V-only operation. In a 5 V-only operation, the above mentioned problems with respect to the circuit of Fig. 1 become more serious.

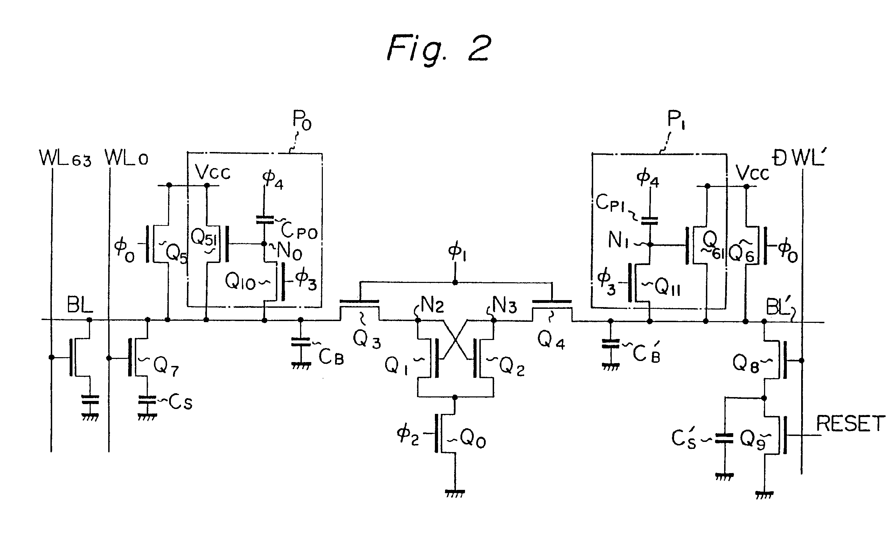

In order to overcome the above disadvantages of the circuit of Fig. 1, a second example of a conventional device has been proposed. Fig. 2 is a circuit diagram illustrating a part of the second example of a conventional device. The main difference between the circuits of Figs. 1 and 2 is that, in Fig. 2, pull up circuits $P_0$ and $P_1$ are associated on both sides of the sense amplifier. The other portions are quite similar to each other. The pull up circuit $P_0$ associated to the bit line BL comprises a transistor $Q_{51}$ connected between the power supply line $V_{CC}$ and the bit line BL, a transistor $Q_{10}$ connected between the gate of the transistor $Q_{51}$ and the bit line BL, and a capacitor $C_{P0}$ whose one end is connected to the gate of the transistor $Q_{51}$. The pull up circuit $P_1$ associated with the bit line BL' also comprises transistors $Q_{61}$ and $Q_{11}$ and a capacitor $C_{P1}$ connected in the same configuration as the pull up circuit $P_0$. The clock signals $\phi_0$, $\phi_1$ and $\phi_2$ are applied to the gates of the transistors $Q_5$ and $Q_6$, to the gates of the transistors $Q_3$ and $Q_4$ and to the gate of the transistor $Q_0$, respectively, in the same manner as in the circuit of Fig. 1. In the pull up circuit $P_0$, additional clock signals $\phi_3$ and $\phi_4$ are applied to the gate of the transistors $Q_{10}$ and to the other end of the capacitor $C_{P0}$, respectively. Also, in the pull up circuit $P_1$, these signals $\phi_3$ and $\phi_4$ are applied to the gate of the transistor $Q_{11}$ and to the end of the capacitor $C_{P1}$, respectively.

Fig. 3 is a time chart illustrating waveforms for the circuit of Fig. 2. Referring to Fig. 3, the wave forms of the potentials of the clock signals $\phi_0$, $\phi_1$, $\phi_2$, $\phi_3$ and $\phi_4$ of the reset signal RESET, of the word line $WL_0$ of the dummy word line DWL', of the bit lines BL and BL', and of nodes $N_0$ and $N_1$ connected to the gates of the transistors $Q_{51}$ and $Q_{61}$, respectively, are illustrated. The precharge period is that the time before a time $t_0$ when the clock signal $\phi_0$ and the reset signal RESET are turned to low. During this precharge period, the bit lines BL and BL' are charged up to the $V_{CC}$ level through the transistors $Q_5$ and $Q_6$, respectively. The transistors $Q_5$ and $Q_6$ can therefore be termed precharging transistors, and the clock signal $\phi_0$ the precharging clock signal. After the

time $t_0$, at a time $t_1$, the word line $WL_0$ and the dummy word line DWL' begin to rise. Then, the potential of the bit line BL' begin to fall slightly due to the fact that the charges on the bit line BL' begin to flow through the transistor $Q_8$ into the dummy capacitor $C_S'$ which has been storing no charge. However, since the capacitor $C_S$ has been storing information "1", no charge flows through the transistor $Q_7$ and therefore, the potential of the bit line BL does not fall. After this, at a time $t_2$, the clock signal $\phi_1$ is lowered to the $V_{CC}$ level so that the transistors $Q_3$ and $Q_4$ are turned off. After the transistors $Q_3$ and $Q_4$ are turned off, the clock signal $\phi_2$ is raised so that the transistor $Q_0$ is turned on. At this time, since the potential at node $N_2$ connected to the bit line BL through the transistor $Q_3$ is higher than the potential at node $N_3$ connected to the bit line BL' through the transistor $Q_4$, current conducting through the transistor $Q_2$ is larger than that conducting through the transistor $Q_1$. Thus, the transistors $Q_1$ and $Q_2$ are fixed to their off and on states, respectively. The reading operation is thus completed. Since the charges on the node $N_3$ pass through the transistors $Q_2$ and $Q_0$ to the ground, the potential at the node $N_3$ is lowered to zero volts. Therefore, when the voltage between the gate of the transistor $Q_4$ and the node $N_3$ becomes larger than its threshold voltage, the transistor $Q_4$ is turned on again, and charges on the bit line BL' flow through the transistors $Q_4$, $Q_2$ and $Q_0$ to the ground. Then, at a time $t_3$, when the clock signal $\phi_3$ falls to the $V_{CC}$ level and the clock signal $\phi_4$ rises to the $V_{CC}$ level, the restore operation begins. In the restore operation, the transistor $Q_{10}$ is turned to a cut off state, and thus the node $N_0$ is boosted by the clock signal $\phi_4$ through the capacitor $C_{p0}$ to ensure that the potential at the node $N_0$ goes higher than the threshold voltage of the transistor $Q_{51}$ plus the $V_{CC}$ to turn it on. Thus, during the restore operation, the power supply voltage $V_{CC}$ is applied through the transistor $Q_{51}$ to the bit line BL. However, the transistor $Q_{11}$ in the pull up circuit $P_1$ is kept at its on state even after the clock signal $\phi_3$ falls to the $V_{CC}$ level because the potential of the bit line BL' has been greatly reduced. Therefore, charges on the node $N_1$ are conducted through the transistors $Q_{11}$, $Q_4$, $Q_2$ and $Q_0$ to the ground. Accordingly, the potentials of the node $N_1$ and the bit line BL' go low as illustrated. By using the circuit of Fig. 2, since the potential of the bit line BL is charged up to the $V_{CC}$ level by the clock signal $\phi_4$ through the transistor $Q_{51}$ a predetermined time after the clock signal $\phi_0$ is turned to zero, sufficient charges are restored into the memory capacitor $C_S$. In contrast to this, by using the circuit of Fig. 1, the transistor $Q_5$ is in a cut off state after the clock signal $\phi_0$ is turned to zero, so that the potential of the bit line BL goes low due to junction leakage or leakage of the current through the sense amplifier.

The circuit of Fig. 2 has, however, a disadvantage in that it requires a number of types of clock signals. Particularly, it is difficult to set the timing and potential levels of the clock signal $\phi_3$ to be applied.

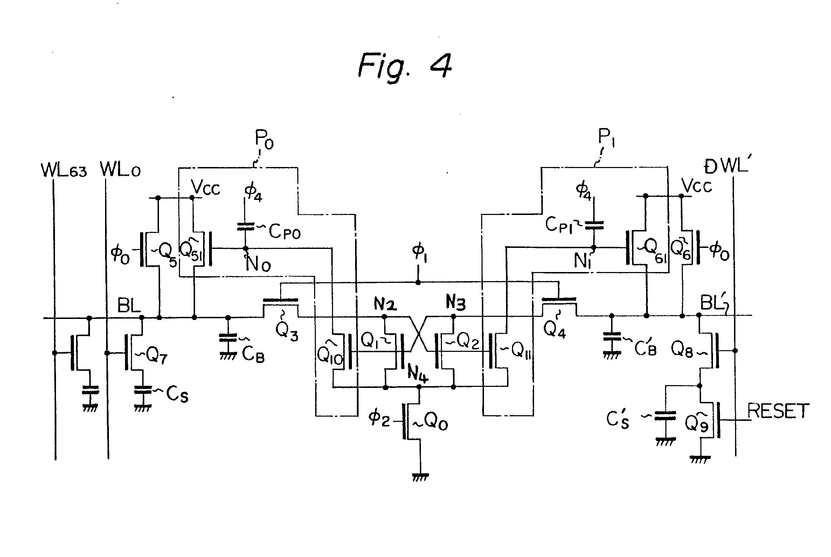

Now, a preferred embodiment according to the present invention will be explained in detail in conjunction with Figs. 4 and 5. Fig. 4 is a circuit diagram illustrating a part of a dynamic semiconductor memory device according to an embodiment of the present invention. The main difference between this circuit of Fig. 4 and the conventional circuit of Fig. 2 resides in the circuit configuration of the pull up circuits $P_0$ and $P_1$. In the circuit of Fig. 4, the drain (or the source) of the transistor $Q_{10}$ is connected to the node $N_0$ to which are connected the gate of the switching transistor $Q_{51}$, which is used to charge up the bit line BL, and one end of the capacitor $C_{p0}$, which connections are the same as those in the circuit of Fig. 2. However, the source (or the drain) of the transistor $Q_{10}$ in Fig. 4 is connected to the ground side of the sense amplifier, that is, to the sources (or the drains) of the transistors $Q_1$ and $Q_2$, instead of being connected to the bit line BL, as was the case in Fig. 2. Also, the gate of the transistor $Q_{10}$ is connected to the gate of the transistor $Q_1$ in the sense amplifier, instead of being connected to the clock signal $\phi_3$. Similarly, in the pull up circuit $P_1$ on the right-land side of Fig. 4, the drain (or the source) of the transistor $Q_{11}$ is connected to the node $N_1$ to which are connected the gate of the switching transistor $Q_{61}$, which is used to charge up the bit line BL', and one end of the capacitor $C_{p1}$, as was the case in the circuit of Fig. 2; the source (or the drain) of the transistor $Q_{11}$ is connected to the ground side ($N_4$) of the sense amplifier; and the gate of the transistor $Q_{11}$ is connected to the gate of the transistor $Q_2$. Thus, in Fig. 4, the clock signal $\phi_3$ is unnecessary and does not appear. The other portions are quite the same as those in the circuit of Fig. 2, and therefore, are not described here.

Fig. 5 is a time chart illustrating waveforms for the circuit of Fig. 4. Referring to Figs. 4 and 5, the operation of the circuit of Fig. 4 will now be explained. Before a time $t_0$, the precharging clock signal $\phi_0$ and the reset signal RESET are higher than $V_{CC}$ plus $V_{TH}$ so that the precharging transistors $Q_5$, $Q_6$ and transistor $Q_9$ are kept to the on states. Thus, the capacitors $C_B$ and $C_B'$ of the bit lines BL and BL', respectively, are charged up to $V_{CC}$ level. Charges stored in the dummy memory capacitor $C_S'$ flow through transistor $Q_9$ to the ground. At a time $t_1$, the word line $WL_0$ and the dummy word line DWL' are selected to begin to rise. At a time $t_2$, the bit line BL' begins to fall slightly because charges in the capacitor $C_B'$ of the bit line BL' begin to flow through the transistor $Q_8$ into the dummy memory capacitor $C_S'$, while the potential of the bit line BL on the real cell side is not changed because of the real memory capacitor $C_S$ storing information "1". At a time $t_3$, the clock signal $\phi_1$ is turned from a higher level (higher than $V_{CC}+V_{TH}$) to the $V_{CC}$ level, so as to ensure that the transfer gate transistors $Q_3$ and $Q_4$ are turned off. Then, slightly later, at a time $t_4$, the clock signal $\phi_2$ begins to rise, so that the sense amplifier operates to amplify the slight potential difference between the bit lines BL and BL'. Thus, the transistor $Q_2$ is directed to its on state and the transistor $Q_1$ is

directed to its off state. Therefore, the potential difference between the bit lines BL and BL' is increased. Both of the potentials of the bit lines BL and BL' begins to be lowered due to junction leakage or leakage of the current through the transistors $Q_0$, $Q_1$ and $Q_2$, and at a time $t_5$, the clock signal $\phi_4$ begins to rise. Since the transistor $Q_{10}$ in the pull up circuit $P_0$ is in its cut off state, because a lower potential is being applied to its gate, the node $N_0$ is boosted to a higher level than $V_{CC}$. While, since the transistor $Q_{11}$ in the pull up circuit $P_1$ is in its on state, because a higher potential is being applied to its gate, charges on the node $N_1$ flow through the transistors $Q_{11}$ and $Q_0$ to the ground. As a result, the transistor $Q_{51}$ is turned on to ensure that the potential of the bit line BL is charged up by charges from $V_{CC}$ through the transistor $Q_{51}$. Thus, the memory capacitor $C_S$ is sufficiently restored by charges stored in the capacitor $C_B$ of the bit line BL through the transistor $Q_7$.

Since the turning on or off of the transistors $Q_{10}$ and $Q_{11}$ is effected depending on the operation of the sense amplifier, as described above, the clock signal $\phi_3$ is not necessary in this embodiment of the present invention.

From the foregoing description, it will be apparent that, according to the present invention, since the transistors for determining whether or not to activate a pull up circuit, included in a dynamic semiconductor memory device, are controlled by the potential level of the bit lines connected to both sides of a sense amplifier, and are not controlled by another clock signal, the problems in setting the potential levels and in determining the timings of the clock signals to be applied are easily solved. Further, the whole design of the dynamic semiconductor memory device is greatly simplified.

**Claim**

A dynamic semiconductor memory device comprising:

a plurality of dynamic memory cells ($Q_7$, $C_S$, $Q_8$, $C'_S$) arranged in a matrix;

a sense amplifier ($Q_1$, $Q_2$) associated with a pair of bit lines (BL, BL') connected to memory cells of the matrix, having a first node ($N_2$) associated with one (BL) of said bit lines and a second node ($N_3$) associated with the other (BL') of said bit lines for providing the outputs of said sense amplifier, and comprising first and second sense amplifier transistors ($Q_1$, $Q_2$), the drains or sources of the respective transistors being connected to respective one of the first and second nodes, the gate of each transistor being connected to the drain or source of the other, and the sources or drains of the transistors being connected to one another at a common connection point ($N_4$), and a further transistor ($Q_0$) connected between said common connection point and a lower potential power supply line of the device;

pull up circuitry ($P_0$, $P_1$) asociated with said pair of bit lines for charging up the bit lines;

in which said pull up circuitry comprises:

a first capacitor ($C_{p0}$) having one end connected to receive a clock signal ($\phi_4$) generated following a memory cell reading operation, for a restoration operation for restoring charge to a read memory cell;

a second capacitor ($C_{p1}$) having one end connected to receive said clock signal ($\phi_4$);

a first switching transistor ($Q_{51}$) connected between a higher potential power supply line ($V_{CC}$) and said one (BL) of said bit lines, and having a gate connected to the other end of the first capacitor ($C_{p0}$);

a second switching transistor ($Q_{61}$) connected between said higher potential power supply line ($V_{CC}$) and said other (BL') of said bit lines, and having a gate connected to the other end of the second capacitor ($C_{p1}$);

a third switching transistor ($Q_{10}$) connected between the gate of said first switching transistor ($Q_{51}$) and the said common connection point ($N_4$), and having a gate connected to said second node ($N_3$);

a fourth switching transistor ($Q_{11}$) connected between the gate of said second switching transistor ($Q_{61}$) and the said common connection point ($N_4$), and having a gate connected to said first node ($N_2$);

a first precharging transistor ($Q_5$) connected between a potential supply line ($V_{CC}$) and said one (BL) of said bit lines, and having a gate adapted to receive a precharging clock signal ($\phi_0$) for precharging said other (BL') of said bit lines; characterised in that

the said other end of the first capacitor ($C_{p0}$) is connected solely to the gate of the first switching transistor ($Q_{51}$) and to the third switching transistor ($Q_{10}$);

the said other end of the second capacitor ($C_{p1}$) is connected solely to the gate of the second switching transistor ($Q_{61}$) and to the fourth switching transistor ($Q_{11}$); and in that

the said potential supply line ($V_{CC}$) with which the first ($Q_5$) and second ($Q_6$) precharging transistors are connected is said higher potential power supply line ($V_{CC}$); and in that

a first transfer gate transistor ($Q_3$) is conected between said one (BL) of said pair of bit lines and said first node ($N_2$); and

a second transfer gate transistor ($Q_4$) is connected between said other (BL') of said pair of bit lines und said second node ($N_3$);

said first transfer gate transistor ($Q_3$) and said second transfer gate transistor ($Q_4$) having gates for receiving a further clock signal ($\phi_1$) for turning those transistors off after the potentials of said pair of bit lines (BL, BL') begin to change from a precharged level during a memory cell reading operation.

**Patentansprüch**

Dynamische Halbleiterspeichervorrichtung mit: einer Vielzahl von dynamischen Speicherzellen ($Q_7$, $C_S$, $Q_8$, $C'_S$), die in einer Matrix angeordnet

sind;

einem Leseverstärker ($Q_1$, $Q_2$), der einem Paar von Bitleitungen (BL, BL') zugeordnet ist, die mit Speicherzellen der Matrix verbunden sind und einen ersten Knotenpunkt ($N_2$) haben, der einer (BL) der genannten Bitleitungen zugeordnet ist, und einen zweiten Knotenpunkt ($N_3$), der der anderen (BL') der genannten Bitleitungen zugeordnet ist, um die Ausgänge des genannten Leseverstärkers zu liefern, und mit ersten und zweiten Lesverstärkertransistoren ($Q_1$, $Q_2$), deren Drains oder Sourcen jeweils mit entspre- chenden der ersten und zweiten Knotenpunkte verbunden sind, wobei das Gate von jedem Transistor mit dem Drain oder der Source des anderen verbunden ist und die Sourcen oder Drains der Transistoren miteinander bei einem gemeinsamen Verbindungspunkt ($N_4$) verbunden sind, und ferner mit einem Transistor ($Q_0$), der zwischen dem gemeinsamen Verbindungspunkt und einer Energieversorgungsleitung niedrigeren Potentials der Vorrichtung verbunden ist;

einer pull-up-Schaltung ($P_0$, $P_1$), die dem genannten Paar von Bitleitungen zugeordnet ist, um die Bitleitungen aufzuladen;

bei welcher die genannte pull-up-Schaltung umfaßt:

einen ersten Kondensator ($C_{p0}$), dessen eines Ende angeschlossen ist, um ein Taktsignal ($\phi_4$) zu empfangen, das nach dem Lesebetrieb einer Speicherzelle erzeugt wird, für einen Wiederherstellungsbetrieb zum Wiederherstellen der Ladung für eine Lesespeicherzelle;

einen zweiten Kondensator ($C_{p1}$), dessen eines Ende angeschlossen ist, um das genannte Taktsignal ($\phi_4$) zu empfangen;

einen ersten Schalttransistor ($Q_{51}$), der zwischen einer Energieversorgungsleitung höheren Potentials ($V_{cc}$) und der genannten einen (BL) der genannten Bitleitungen verbunden ist und ein Gate hat, das mit dem anderen Ende des ersten Kondensators ($C_{p0}$) verbunden ist;

einen zweiten Schalttransistor ($Q_{61}$), der zwischen der genannten Energieversorgungsleitung höheren Potentials ($V_{cc}$) und der genannten anderen (BL') der genannten Bitleitungen verbunden ist und ein Gate hat, das mit dem anderen Ende des zweiten Kondensators ($C_{p1}$) verbunden ist;

einem dritten Schalttransistor ($Q_{10}$), der zwischen dem Gate des genannten ersten Schalttran- sistors ($Q_{51}$) und dem genannten gemeinsamen Verbin- dungspunkt ($N_4$) verbunden ist und ein Gate hat, das mit dem genannten zweiten Knotenpunkt ($N_3$) verbunden ist;

einen vierten Schalttransistor ($Q_{11}$), der zwischen dem Gate des genannten zweiten Transistors ($Q_{61}$) und dem genannten gemeinsamen Verbindungspunkt ($N_4$) verbunden ist und ein Gate hat, das mit dem genannten ersten Knotenpunkt ($N_2$) verbunden ist;

einen ersten Vorladungs-Transistor ($Q_5$), der zwischen einer Potentialversorgungsleitung ($V_{cc}$) und der genannten einen (BL) der genannten Bitleitungen verbunden ist und ein Gate hat, das angepaßt ist, um ein Vorladungs-Taktsignal ($\phi_0$) zum Vorladen der genannten einen (BL) der genannten Bitleitungen zu empfangen;

einen zweiten Vorladungs-Transistor ($Q_6$), der zwischen der Potentialversorgungsleitung ($V_{cc}$) und der genannten anderen (BL') der genannten Bitleitungen angeschlossen ist und ein Gate hat, das angepaßt ist, um das genannte Vorladungs-Taktsignal ($\phi_0$) zum Vorladen der genannten anderen (BL') der genannten Bitleitungen zu empfangen; dadurch gekennzeichnet, daß

das genannte andere Ende des ersten Kondensators ($C_{p0}$) lediglich mit dem Gate des ersten Schalttransistors ($Q_{51}$) und mit dem dritten Schalttransistor ($Q_{10}$) verbunden ist;

das genannte andere Ende des zweiten Kondensators ($C_{p1}$) lediglich mit dem Gate des genannten Schalttransistors ($Q_{61}$) und dem vierten Schalttransistor ($Q_{11}$) verbunden ist; und daß

die genannte Potentialversorgungsleitung ($V_{cc}$), mit welcher die ersten ($Q_5$) und zweiten ($Q_6$) Vorladungstransistoren verbunden sind, eine Energieversorgungsleitung ($V_{cc}$) höheren Potentials ist; und daß

ein erster Transfergatetransistor ($Q_3$) zwischen der genannten einen (BL) des genannten Paares von Bitleitungen und dem genannten ersten Knotenpunkt ($N_2$) verbunden ist; und

ein zweiter Transfergatetransistor ($Q_4$) zwischen der genannten anderen (BL') des genannten Paares von Bitleitungen und dem genannten zweiten Knotenpunkt ($N_3$) verbunden ist;

und der genannte erste Transfergatetransistor ($Q_3$) und der genannte zweite Transfergatetransistor ($Q_4$) Gates zum Empfang eines weiteren Taktsignals ($\phi_1$) haben, zum Einschalten derjenigen Transistoren, nachdem die Potential der genannten Paare von Bitleitungen (BL, BL') während des Speicherzellen- lesebetriebs sich von einem vorgeladenen Pegel zu verändern beginnen.

**Revendication**

1. Dispositif de mémoire à semiconducteur dynamique comprenant:

un ensemble de cellules de mémoire dynamique ($Q_7$, $C_s$, $Q_8$, $C_s'$) disposées en une matrice;

un amplificateur de détecteion ($Q_1$, $Q_2$) associé à une paire de fils de bit (BL, BL') connectés aux cellules de mémoire de la matrice, comportant un premier noeud ($N_2$) associé à un fil (BL) des fils de bit et un second noeud ($N_3$) associé à l'autre (BL') des fils de bit pour fournir les signaux de sortie de l'amplificateur de détection, et comprenant des premier et deuxième transistors d'amplificateur de détection ($Q_1$, $Q_2$), les drains ou les sources des transistors respectifs étant connectés aux noeuds respectifs du premier et second noeuds, la grille de chaque transistor étant connectée au drain ou à la source de l'autre, et les sources ou drains des transistors étant connectés entre eux en un point de connexion commun ($N_4$), et un autre transistor ($Q_0$) connecté entre le point de connexion commun et une ligne de tension d'alimentation inférieure du dispositif;

des circuits élévateurs ($P_0$, $P_1$) associés à la paire de fils de bit pour charger les fils de bit;

dans lequel les circuits élévateurs comprennent:

un premier condensateur ($C_{p0}$) ayant une extrémité connectée pour recevoir un signal d'horloge ($\phi_4$) engendré à la suite d'une opération de lecture de cellule de mémoire, pendant une opération de remise à l'état initial pour rétablir une charge dans une cellule de mémoire lue;

un second condensateur ($C_{p1}$) comportant une extrémité connectée pour recevoir le signal d'horloge ($\phi_4$);

un premier transistor de commutation ($Q_{51}$) connecté entre une ligne de tension d'alimentation supérieure ($V_{CC}$) et ledit fil (BL) des fils de bit, et comportant une grille connectée à l'autre extrémité du premier condensateur ($C_{p0}$);

un deuxième transistor de commutation ($Q_{61}$) connecté entre la ligne de tension d'alimentation supérieure ($V_{CC}$) et l'autre fil (BL') des fils de bit, et comportant une grille connectée à l'autre extrémité du second condensateur ($C_{p1}$);

un troisième transistor de commutation ($Q_{10}$) connecté entre la grille du premier transistor de commutation ($Q_{51}$) et le point de connexion commun ($N_4$), et comportant une grille connectée au second noeud ($N_3$);

un quatrième transistor de commutation ($Q_{11}$) connecté entre la grille du deuxième transistor de commutation ($Q_{61}$) et le point de connexion commun ($N_4$), et comportant une grille connectée au premier noeud ($N_2$);

un premier transistor de précharge ($Q_5$) connecté entre une ligne de tension d'alimentation ($V_{CC}$) et ledit fil (BL) des fils de bit, et comportant une grille adaptée pour recevoir un signal d'horloge de précharge ($\phi_0$) pour précharger ledit fil (BL) des fils de bit;

un second transistor de précharge ($Q_6$) connecté entre la ligne de tension d'alimentation ($V_{CC}$) et l'autre (BL') des fils de bit et comportant une grille adaptée pour recevoir le signal d'horloge de précharge ($\phi_0$) pour précharger l'autre (BL') des fils de bit; caractérisé en ce que

l'autre extrémité du premier condensateur ($C_{p0}$) n'est connectée qu'à la grille du premier transistor de commutation ($Q_{51}$) et au troisième transistor de commutation ($Q_{10}$);

l'autre extrémité du second condensateur ($C_{p1}$) n'est connectée qu'à la grille du deuxième transistor de commutation ($Q_{61}$) et au quatrième transistor de commutaiton ($Q_{11}$); en ce que

la ligne de tension d'alimentation ($V_{CC}$) à laquelle sont connectés les premier ($Q_5$) et second ($Q_6$) transistors de précharge est ladite ligne de tension d'alimentation supérieure ($V_{CC}$); et en ce que

un premier transistor à porte de transfert ($Q_3$) est connecté entre ledit fil (BL) de la paire de fils de bit et le premier noeud ($N_2$); et

un second transistor à porte de transfert ($Q_4$) est connecté entre l'autre (BL') de la paire de fils de bit et le second noeud ($N_3$);

le premier transistor à porte de transfert ($Q_3$) et le second transistor à porte de transfert ($Q_4$) comportent des grilles pour recevoir un autre signal d'horloge ($\phi_1$) servant à mettre ces transistors à l'état bloqué après que les potentiels de la paire de fils de bit (BL, BL') ont commencé à varier à partir d'un niveau préchargé pendant une opération de lecture de cellule de mémoire.

# Fig. 1

# Fig. 2

## Fig. 3

## Fig. 5

*Fig. 4*

4